# EUROPEAN PATENT SPECIFICATION

(11) **EP 4 184 770 B1**
(45) Date of publication and mention of the grant of the patent: **09.09.2026**
(21) Application number: 21209815.6
(22) Date of filing: 23.11.2021
(51) Int. Cl.: H02M 1/00, H02M 3/335, H02M 7/48, H02M 3/337, G01R 19/00

(54) **AN ISOLATED SWITCHED RESONANT CONVERTER**
ISOLIERTER GESCHALTETER RESONANZWANDLER
CONVERTISSEUR RÉSONANT À COMMUTATION ISOLÉ

(43) Date of publication of application: 24.05.2023
(73) Proprietor: Tridonic GmbH & Co. KG, 6851 Dornbirn (AT)
(72) Inventor: SCHNEIDER, Miguel Philipp, 6850 Dornbirn (AT)
(74) Representative: Rupp, Christian

(56) References cited:
- EP-A1- 3 767 816
- WO-A1-2020/109090
- CN-A- 107 733 234
- US-A- 5 179 512
- US-A1- 2015 162 887
- US-A1- 2017 231 039
- US-A1- 2019 149 057
- US-A1- 2020 144 905
- US-A1- 2020 150 154
- SCHONEMAN G K ET AL: "OUTPUT IMPEDANCE CONSIDERATIONS FOR SWITCHING REGULATORS WITH CURRENT-INJECTED CONTROL", IEEE TRANSACTIONS ON POWER ELECTRONICS, INSTITUTE OF ELECTRICAL AND ELECTRONICS ENGINEERS, USA, vol. 4, no. 1, 1 January 1989 (1989-01-01), pages 25 - 35, XP000028677, ISSN: 0885-8993, DOI: 10.1109/63.21870

## Description

### TECHNICAL FIELD OF THE INVENTION

The invention is in the area of isolated switched resonant converters, such as, for example, isolated LCC resonant converters. The invention deals, in particular, with the aspect of generating a feedback signal for a feedback control unit for setting the operation parameters of the switching of the isolated switched resonant converter.

### BACKGROUND OF THE INVENTION

Resonant converters represent a convenient alternative to other type of traditional converters due to their characteristics such as reduced switching losses and electromagnetic interference due to the sinusoidal behavior of the resonant circuit. Such converters can operate at high frequencies and, thus, reduce the size of their reactive components. In these converters, the so-called storage tank can consist of two or three storage elements. The resonant tank can be divided into three groups: series, parallel and series-parallel. In turn, converters with series-parallel resonant tanks can be classified as LLC and LCC.

LLC and LCC converters are often used in the field of LEDs. For example, in order to operate a LED module, a control gear (a ballast) is required which is also called a driver, wherein the driver can comprise a LLC or LCC converter.

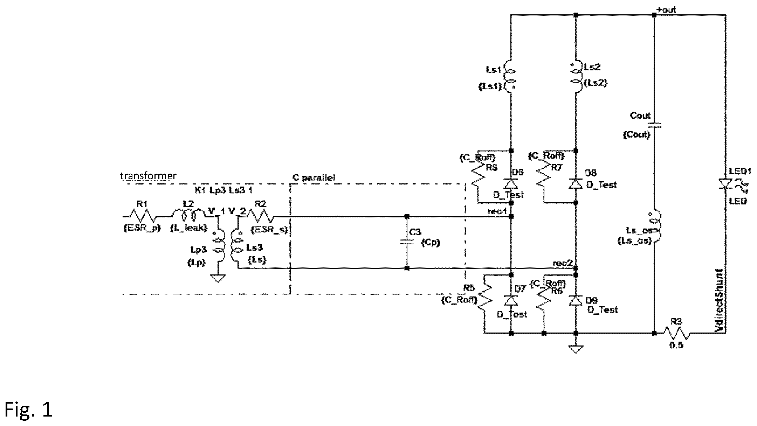

Fig. 1 shows a schematic representation of a converter for a LED module according to prior art. In this configuration, the converter is used to supply the LED load (LED lighting means). In this configuration, moreover, a current sense transformer is positioned in series to power rectifying diodes in order to measure the current flowing through the LED load. Thereby, sensing windings are used in series to the diodes of the rectifier stage arranged between the secondary winding of the sense transformer and the output capacitor supplying the LED load.

However, it would be desirable to provide solutions for sensing the current through a LED module which are more accurate and flexible than in the prior art.

Therefore, it is an objective of this disclosure to provide an improved LED converter for accurately and flexibly sensing the current flowing through a LED module.

Prior art documents disclosing resonant converters with current sensing transformers are, for example, CN107733234A and US2020150154A1. A differential current transformer is disclosed in US2015162887A1.

### SUMMARY OF THE INVENTION

The object of the present invention is achieved by the solution provided in the enclosed independent claims. Advantageous implementations of the present invention are further defined in the dependent claims.

According to a first aspect, the disclosure relates to an isolated switched resonant converter for suppling a LED load. The isolated switched resonant converter comprises a switching stage having at least one switch driven by a control circuit of the converter, a resonance circuit supplied by the switching stage, a transformer as an isolation stage, a resonance capacitor, wherein the resonance capacitor is arranged in parallel to a secondary side winding of the transformer, wherein the secondary side winding is arranged to supply output terminals of the converter for supplying the LED load, detection means configured to detect a signal representing a differential current based on a difference between a first current flowing through the secondary side winding and a second current flowing through the capacitor, wherein the signal representing the differential current is supplied to the control circuit.

Since the signal representing the differential current is essentially equal to the current flowing through a LED load (when connected to the output terminals), this provides the advantage that the current flowing through the secondary side of the converter can accurately and flexibly be detected.

Further, the detection means comprises a sense transformer configured to detect the signal representing the differential current and a first rectifier stage configured to rectify the signal representing the differential current.

In particular, the signal representing the differential current can be seen as a feedback signal, wherein the feedback signal is tapped off the secondary side of the isolation stage of the isolated converter and is, typically, fed back also in an isolated manner using the sense transformer on the secondary side of the transformer of the converter.

The first rectifier stage can comprise four rectifying diodes. This provides the advantage that a well-known rectifying stage can be used in order to rectify the signal representing the differential current.

In addition, the sense transformer comprises a first primary side winding, which is connected in series to the secondary side winding of the transformer, a second primary side winding arranged in series to the resonance capacitor, and a secondary side winding, wherein the secondary side winding is coupled to the first primary side winding and to the second primary side winding of the sense transformer.

In particular, the secondary side winding of the sense transformer is configured to sense the signal representing the differential current based on a difference between a current flowing through the first primary side winding and a current flowing through the second primary side winding.

In a preferred embodiment, the first primary side winding comprises a first bifilar winding and the second primary side winding comprise a second bifilar winding.

This provides the advantage that well-known windings such as bifilar windings can be used.

In a preferred embodiment, the signal representing the differential current is sensed by means of a shunt resistor.

This provides the advantage that the signal representing the differential current can easily and accurately be measured by means of the shunt resistor.

In a preferred embodiment, the switching stage comprises a half-bridge, HB, circuitry, wherein the HB circuitry comprises two switches in series, wherein the midpoint of the two switches is supplying a resonant circuitry.

This provides the advantage that a well-known switching stage, such as a half-bridge can be used.

In a preferred embodiment, an output signal of the sense transformer is supplied to the control circuit, wherein the control circuit is configured to generate a signal for setting at least one operation parameter of at least one switch of the HB circuitry.

This provides the advantage that the operation parameters of the LED load such as the operational current can accurately be determined due to the setting of the operation parameters of the at least one switch of the HB circuitry. For example, an operational parameter of the LED load is the operational current. Setting the operational parameters of the LED load accurately is advantageous, because in such a way phenomena, which could disturb the observer, such as LED flickering, can be avoided.

In a preferred embodiment, the converter comprises a second rectifier stage configured to rectify a current supplied to the output terminals of the converter for supplying the LED load.

The rectifier stage can comprise four diodes. This provides the advantage that well-known rectifiers can be used to rectify the current supplied to the output terminals of the converter for supplying the LED load.

In a preferred embodiment, the converter comprises an output capacitor, wherein the output capacitor is configured to smooth a current supplied to the output terminals of the converter for supplying the LED load.

In a preferred embodiment, the converter is an LLC converter or an LCC converter.

This provides the advantage that well-known converters which are efficient can be used.

According to a second aspect, the disclosure relates to a LED lighting device comprising an isolated switched resonant converter according to the first aspect or anyone of the preferred embodiments thereof as well as at least one LED module connected to output terminals of the converter.

According to a third aspect, the disclosure relates to a method for detecting a secondary side current of an isolated switched resonant converter, wherein the converter comprises switching stage having at least one switch driven by a control circuit of the converter, a resonance circuit supplied by the switching stage, a transformer as an isolation stage, wherein a resonance capacitor is switched in parallel to a secondary side winding of the transformer, the method comprising the steps of: supplying output terminals of the converter by the secondary side winding for supplying an LED load, detecting a signal representing a differential current based on a difference between a first current flowing through the secondary side winding and a second current flowing through the capacitor, and supplying the signal representing the differential current to the control circuit.

The method according to the third aspect provides the same advantages as the isolated switched resonant converter according to the first aspect and the implementation forms thereof.

### BRIEF DESCRIPTION OF THE DRAWINGS

The invention will be explained in the followings together with the figures.
- Fig. 1: shows a schematic representation of an isolated switched resonance converter according to prior art;
- Fig. 2: shows a schematic representation of an isolated switched resonance converter according to an embodiment;
- Fig. 3: shows a schematic representation of a current sense transformer according to an embodiment;
- Fig. 4: shows a schematic representation of a current sense transformer according to an embodiment;
- Fig. 5: shows schematic representations of signals which are obtained in an isolated switched resonance converter according to an embodiment; and
- Fig. 6: shows a schematic representation of a method for detecting a secondary side current of an isolated switched converter according to an embodiment.

### DETAILED DESCRIPTION OF THE PREFERRED EMBODIMENTS

Aspects of the present invention are described herein in the context of an isolated switched resonant converter for supplying an LED load.

The present invention is described more fully hereinafter with reference to the accompanying drawings, in which various aspects of the present invention are shown. This invention however may be embodied in many different forms and should not be construed as limited to the various aspects of the present invention presented through this disclosure. Rather, these aspects are provided so that this disclosure will be thorough and complete, and will fully convey the scope of the present invention to those skilled in the art. The various aspects of the present invention illustrated in the drawings may not be drawn to scale. Rather, the dimensions of the various features may be expanded or reduced for clarity. In addition, some of the drawings may be simplified for clarity. Thus, the drawings may not depict all of the components of a given apparatus.

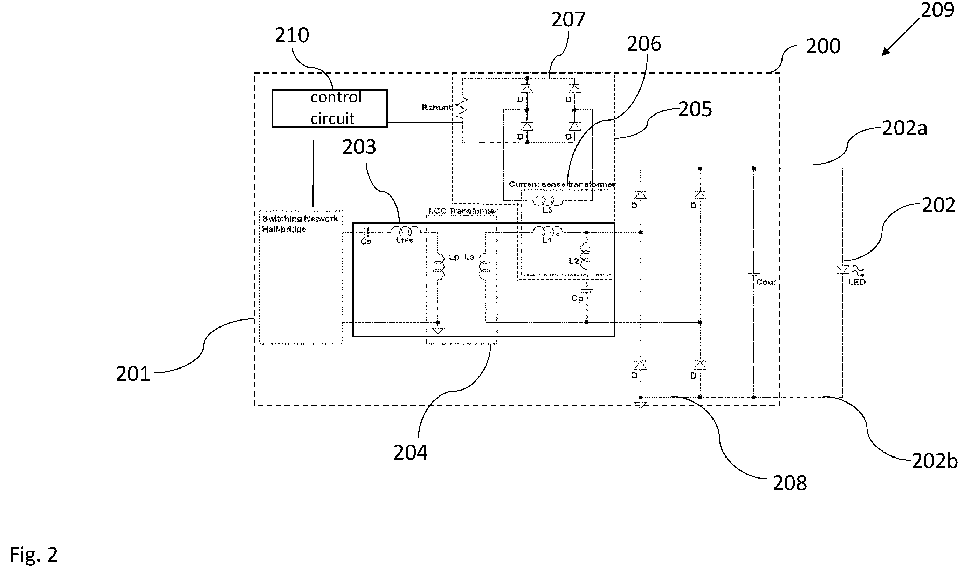

Now referring to Fig. 2, a schematic representation of an isolated switched resonant converter 200 according to the invention is shown.

The isolated switched resonant converter 200 is configured to supply a LED load 202. Moreover, the converter 200 comprises:
- a switching stage 201 having at least one switch driven by a control circuit 210 of the converter 201,
- the control circuit 210, wherein the control circuit 210 can be configured to set operation parameters of the switching stage 201,

- a resonance circuit 203 supplied by the switching stage 201,
- a transformer 204 as an isolation stage,
- a resonance capacitor Cp, wherein the resonance capacitor Cp is arranged in parallel to a secondary side winding Ls of the transformer 204, wherein the secondary side winding Ls is arranged to supply output terminals 202a, 202b of the converter 200 supplying the LED load 202,
- detection means 205 configured to detect a signal representing a differential current based on a difference between a first current flowing through the secondary side winding Ls and a second current flowing through the resonance capacitor Cp, wherein the signal representing the differential current is supplied to the control circuit 210.

The signal representing the differential current can, thus, be a feedback signal for the control circuit 210, which can be a feedback control circuit 210, for setting the operation parameters of the switching stage 201 of the isolated switched resonant converter 200.

The control circuit 210 may implement a feedback control, receiving a nominal value signal, comparing it with the feedback signal, and issuing a signal for setting an operation parameter of the switching stage 201 in order to bring the value of the feedback signal as close as possible to the nominal value.

The nominal value signal can be supplied externally (e.g., via a bus interface such as e.g. a DALI interface of the converter 200 or by a passive element connected to the LED driver e.g. a resistor) or internally (e.g. via a sensor).

The nominal value signal supplied to the control circuit 210 may be varied in order to achieve dimming of a LED load 202 connected to the output terminals 202a, 202b of the converter 200.

The isolated switched resonant converter 200 may be supplied with a constant DC voltage e.g. from a power factor correction circuit or a DC distribution grid. The power factor correction circuit and the isolated switched resonant converter 200 may form a LED driver. Such a LED driver may further comprise a bus interface to receive dimming commands and / or the nominal value signal. The nominal value signal may depend on a dimming signal received via the bus interface or the nominal value signal may be transmitted directly via the bus interface.

The control circuit 210 may be implemented by a single or a plurality of integrated circuits, such as, e.g., a combination of an ASIC (implementing the feedback algorithm) and a microcontroller (e.g., interfacing with a bus and communicating with the ASIC).

Moreover, the converter 200 can be comprised in a driver for driving the LED load 202, and the feedback signal can be used to set LED driver operating parameters, such as, for example, operating current, constant lumen output, and dimming levels.

In the example shown in Fig. 2, the converter 200 comprises a resonance series capacitor Cs, a resonance choke Lres, the resonance capacitor Cp, a first primary side winding L1, a second primary side winding L2, and a secondary side winding L3.

Moreover, in the example shown in Fig. 2, the detection means 205 comprises a sense transformer 206 configured to detect the signal representing the differential current and a first rectifier stage 207 configured to rectify the signal representing the differential current.

The sense transformer 206 can be a current sense transformer and it can comprise the first primary side winding L1, which is connected in series to the secondary side winding Ls of the isolation stage of the converter 200. Thus, any current through the secondary side winding Ls of the isolation stage 201 of the converter 200 will also flow through the first primary side winding L1 of the sense transformer 206.

The further second primary side winding L2 of the current sense transformer 206 can be arranged in series to the resonant capacitor Cp, which can be switched in parallel to the secondary side winding Ls of the transformer 204 of the isolated switched resonant converter 200. Thus, any current through the resonant capacitor Cp (which current is not flowing towards the LED load) will also flow through the second primary side winding L2 of the current sense transformer 206.

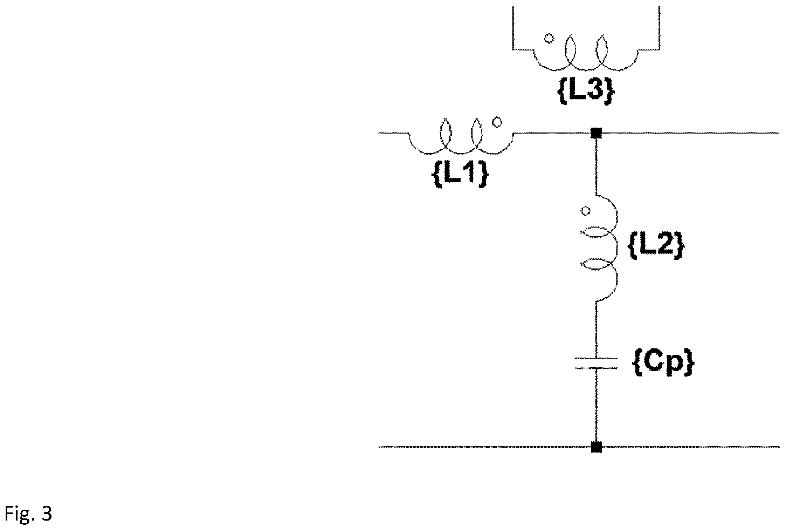

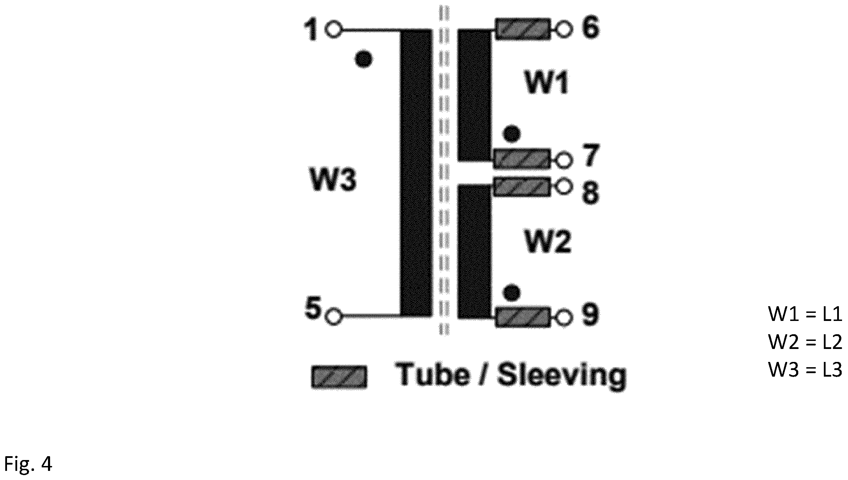

The sense transformer 206 further can comprise a secondary side winding L3 (see also Fig. 3 and Fig. 4), which can be coupled to the primary side windings L1 and L2 of the sense transformer 206, such that the sense transformer 206 can be configured to sense the signal representing the differential current based on the difference between the first current flowing through the first primary side winding L1, and the second current flowing through the second primary side winding L2.

Thus, the secondary side winding L3 of the sense transformer 206 senses only the current actually flowing towards the output terminals 202a, 202b of the converter 200 and, thus, to any connected LED load.

The exemplary converter 200 shown in Fig. 2 can comprise an output capacitor Cout, wherein the output capacitor Cout can be configured to smooth a current supplied to the output terminals 202a, 202b of the converter for supplying the LED load 202.

The sense signal can directly be proportional to the output capacitor Cout charging current. For example, the sense signal can essentially equal the output capacitor Cout charging current. Moreover, the average of the output capacitor charging current can essentially equal the current flowing through the LED load 202.

The output of the secondary side of the current sense transformer (winding L3), namely the signal representing the differential current, can be rectified, for example, using a diode network 207 comprising four rectifying diodes D and, then, sensed through a shunt resistor Rₛₕᵤₙₜ.

For example, the first primary side winding L1 can comprise a first bifilar winding and the second primary side winding L2 can comprise a second bifilar winding. Moreover, the bifilar windings can be used to sense a difference between a resonance current through the secondary side L2 and the capacitive current flowing through the resonant capacitor Cp.

Furthermore, when the resonant current flowing through the secondary side winding L3 of the sense transformer 206 and the capacitive current flow in opposite directions through their windings, the resulting magnetic fields in the sense transformer 206 can cancel each other partly out and what remains is the output capacitor Cout charging current.

Preferably, the switching stage 201 can comprise a half-bridge, HB, wherein the HB can comprise two switches.

In particular, an output signal of the sense transformer 206, e.g., the signal representing the differential current, can be supplied to the control circuit 210, wherein the control circuit 210 can be configured to generate a signal for setting at least one operation parameter of at least one switch of the HB circuitry.

Moreover, the converter 200 can comprise a second rectifier stage 208 configured to rectify a current supplied to the output terminals 202a, 202b of the converter 200 for supplying the LED load 202.

The converter 200 can be an LLC converter or an LCC converter.

In general, the LLC resonant converter can be composed of two inductors and a single resonant capacitor. In particular, the LLC resonant circuit can be formed by the series combination of a magnetizing inductance and low-value leakage inductance of the main transformer, and a combined capacitance on the passive side of the bridge. LLC resonant converters can have several advantages over other resonant converters. For example, they can require a relatively narrow variation of the switching frequency to control the output voltage. Moreover, they can operate with a wide load range, and a zero voltage switching can be achieved over the entire operating range.

In contrast, the LCC resonant converter can be composed of two capacitors and a resonant inductor. The LCC resonant converter can be able to achieve wide operation together with high efficiency. Due to low switching losses, the LCC resonant converter can be able to operate at high switching frequencies, while maintaining high efficiency. The resonant tank of the LCC converter can consist of two capacitors and one series inductor. LCC resonant converters can aim at combining the advantages of the series and parallel converters at the same time reducing their disadvantages. Similarly to the LLC converter, the LCC converter may not require and LC output filter used in a conventional hard-switching half-bridge converter. Moreover, the transformer leakage inductance can be utilized as the resonant element.

In the example shown in Fig. 2, the converter 200 is an LCC converter.

In Fig. 2, also a schematic representation of a LED lighting device 209 is shown which can comprise the isolated switched resonant converter 200 as well as at least one LED module 202 connected to output terminals 202a, 202b of the converter 200.

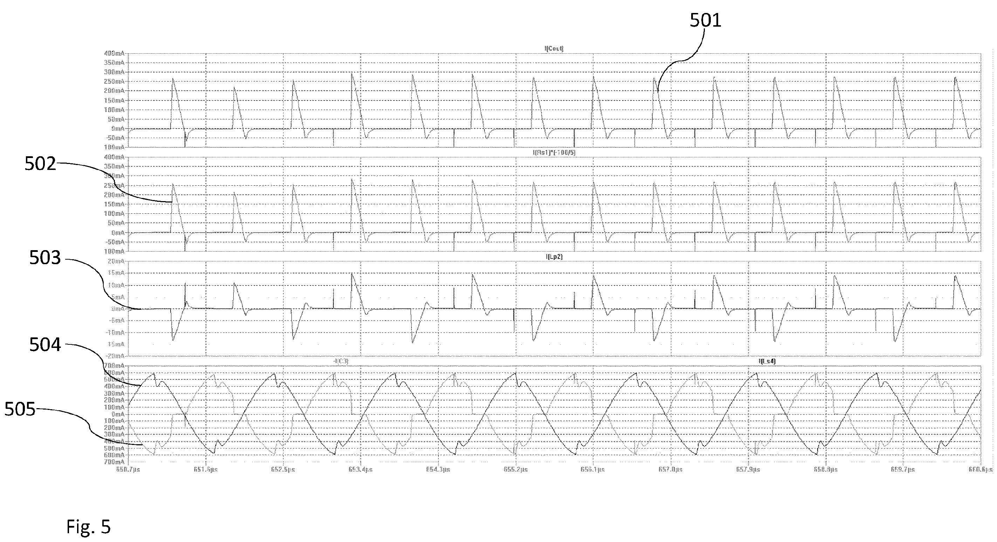

Fig. 5 shows schematic representations of current signals 501, 502, 503, 504 and 505 of the converter 200.

In particular, the signal 501 shows the behavior of the current through the output capacitor Cout. The signal 503 shows the current through the secondary side winding L3 of the sense transformer 206. Therefore, the signal 503 represent the difference signal as sensed through the secondary side winding L3 of the sensing transformer 206. This signal can be rectified and can, then, be an indication of the current flowing through the rectifier network or rectifier stage 208 into the capacitor Cout, supplying the LED load 202 such that this signal 503 (upon rectification) can indicate the current flowing through the LED load 202.

The signal 505 shows the behavior of the current flowing through the parallel capacitance Cp and, thus, through the second primary side winding L2, since L2 and Cp are connected in series. The signal 501 shows the current through the output capacitor Cout, while the signal 502 shows the rectified signal representing the differential current (and scaled by the ration of the transformer 204).

As it can be taken form Fig. 5, the signals 502 and 501 match very well (the signal 502 was scaled just for comparison), meaning that the current flowing through the output capacitor Cout can essentially equal the rectified signal representing the differential current.

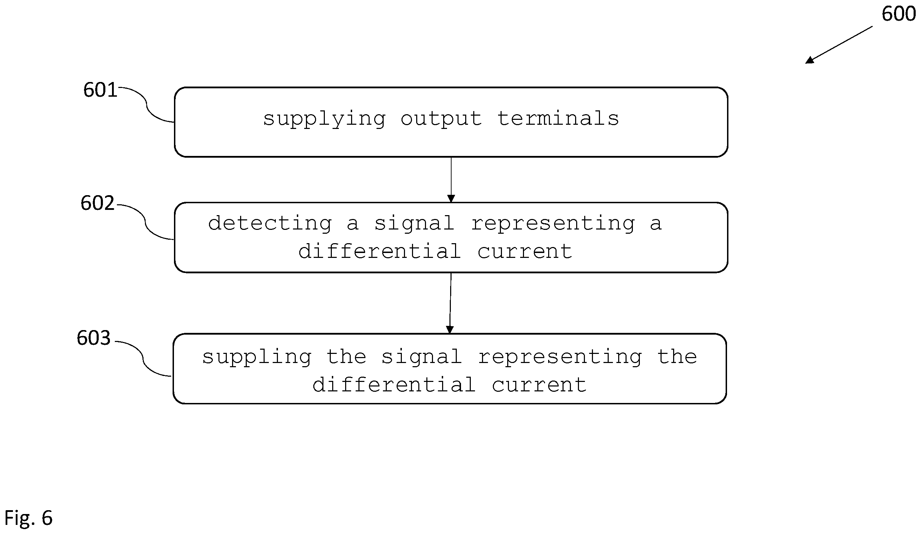

Fig. 6 shows a schematic representation of a method for detecting the secondary side current of the isolated switched resonant converter 200.

The converter 200 comprises a switching stage 201 having at least one switch driven by a control circuit 210 of the converter 200, a resonance circuit 201 supplied by the switching stage, a transformer 204 as an isolation stage, wherein a resonance capacitor Cp is switched in parallel to a secondary side winding Ls of the transformer 204.

The method 600 comprises the steps of:
- supplying 601 output terminals 202a, 202b of the converter 200 by the secondary side winding Ls for supplying the LED load 202,
- detecting 602 a signal representing a differential current based on a difference between a first current flowing through the secondary side winding Ls and a second current flowing through the capacitor Cp, and
- suppling 603 the signal representing the differential current to the control circuit 210.

All features of all embodiments described, shown and/or claimed herein can be combined with each other.

The invention is defined by the appended claims.

Further variations and modifications are possible within the scope of the appended claims.

## Claims

1. Isolated switched resonant converter (200), such as e.g. an LCC converter, for suppling a LED load (202), comprising:
- a switching stage (201) having at least one switch driven by a control circuit (210) of the converter (200),
- a resonance circuit (203) supplied by the switching stage (201),
- a transformer (204) as an isolation stage,
- a resonance capacitor (Cp), wherein the capacitor (Cp) is arranged in parallel to a secondary side winding (Ls) of the transformer (204), wherein the secondary side winding (Ls) is arranged to supply output terminals (202a, 202b) of the converter (200) supplying the LED load (202),
- detection means (205) configured to detect a signal representing a differential current based on a difference between a first current flowing through the secondary side winding (Ls) and a second current flowing through the capacitor (Cp), wherein the signal representing the differential current is supplied to the control circuit (210);
wherein the detection means (205) comprises a sense transformer (206) configured to detect the signal representing the differential current and a first rectifier stage (207) configured to rectify the signal representing the differential current;
wherein the sense transformer (206) comprises a first primary side winding (L1) which is connected in series to the secondary side winding (Ls) of the transformer (204), a second primary side winding (L2) arranged in series to the resonance capacitor (Cp), and a secondary side winding (L3), wherein the secondary side winding (L3) is coupled to the first primary side winding (L1) and to the second primary side winding (L2) of the sense transformer (206);
wherein the secondary side winding (L3) of the sense transformer (206) is configured to sense the signal representing the differential current based on a difference between a current flowing through the first primary side winding (L1) and a current flowing through the second primary side winding (L2).

2. Isolated switched resonant converter (200) according to claim 1, wherein the first primary side winding (L1) comprises a first bifilar winding and the second primary side winding (L2) comprise a second bifilar winding.

3. Isolated switched resonant converter (200) according to anyone of the preceding claims, wherein the signal representing the differential current is sensed by means of a shunt resistor (Rshunt).

4. Isolated switched resonant converter (200) according to anyone of the preceding claims, wherein the switching stage (201) comprises a half-bridge, HB, circuitry, wherein the HB circuitry comprises two switches in series.

5. Isolated switched resonant converter (200) according to claim 4, wherein an output signal of the sense transformer (206) is supplied to the control circuit (210), wherein the control circuit (210) is configured to generate a signal for setting at least one operation parameter of at least one switch of the HB circuitry.

6. Isolated switched resonant converter (200) according to anyone of the preceding claims, wherein the converter (200) comprises a second rectifier stage (208) configured to rectify a current supplied to the output terminals (202a, 202b) of the converter (200) for supplying the LED load (202).

7. Isolated switched resonant converter (200) according to anyone of the preceding claims, wherein the converter (200) comprises an output capacitor (Cout), wherein the output capacitor (Cout) is configured to smooth a current supplied to the output terminals (202a, 202b) of the converter (200) for supplying the LED load (202).

8. Isolated switched resonant converter (200) according to anyone of the preceding claims, wherein the converter (200) is an LLC converter or an LCC converter.

9. LED lighting device (209) comprising an isolated switched resonant converter (200) according to anyone of the preceding claims 1 to 8 as well as at least one LED module (202) connected to output terminals (202a, 202b) of the converter (200).

10. A method (600) for detecting a secondary side current of an isolated switched resonant converter (200), such as e.g. an LCC converter, wherein the converter (200) comprises a switching stage (201) having at least one switch driven by a control circuit (210) of the converter (200), a resonance circuit (203) supplied by the switching stage (201), a transformer (204) as an isolation stage, wherein a resonance capacitor (Cp) is switched in parallel to a secondary side winding (Ls) of the transformer (204), and a sense transformer (206) comprising a first primary side winding (L1) which is connected in series to the secondary side winding (Ls) of the transformer (204), a second primary side winding (L2) arranged in series to the resonance capacitor (Cp), and a secondary side winding (L3), wherein the secondary side winding (L3) is coupled to the first primary side winding (L1) and to the second primary side winding (L2) of the sense transformer (206); the method (600) comprising the steps of:
- supplying (601) output terminals (202a, 202b) of the converter (200) by the secondary side winding (Ls) for supplying an LED load (202),
- detecting (602) a signal representing a differential current based on a difference between a first current flowing through the secondary side winding (Ls) and a second current flowing through the capacitor (Cp), and
- suppling (203) the signal representing the differential current to the control circuit (210),
wherein the converter (200) further comprises a first rectifier stage (207) configured to rectify the signal representing the differential current, and
wherein detecting (602) a signal representing a differential current comprises:
sensing the signal representing the differential current based on a difference between a current flowing through the first primary side winding (L1) and a current flowing through the second primary side winding (L2).

## Patentansprüche

1. Isolierter getakteter Resonanzwandler (200), wie z. B. ein LCC-Wandler, zur Versorgung einer LED-Last (202), umfassend:
- eine Schaltstufe (201) mit mindestens einem Schalter, der durch eine Steuerschaltung (210) des Wandlers (200) angesteuert wird,
- einen Resonanzkreis (203), der durch die Schaltstufe (201) versorgt wird,
- einen Transformator (204) als Isolationsstufe,
- einen Resonanzkondensator (Cp), wobei der Resonanzkondensator (Cp) parallel zu einer sekundärseitigen Wicklung (Ls) des Transformators (204) angeordnet ist, wobei die sekundärseitige Wicklung (Ls) dazu eingerichtet ist, Ausgangsanschlüsse (202a, 202b) des Wandlers (200), die die LED-Last (202) versorgen, zu versorgen,
- Erfassungsmittel (205), die dazu eingerichtet sind, ein einen Differenzstrom repräsentierendes Signal auf Grundlage einer Differenz zwischen einem ersten Strom, der durch die sekundärseitige Wicklung (Ls) fließt, und einem zweiten Strom, der durch den Kondensator (Cp) fließt, zu erfassen, wobei das den Differenzstrom repräsentierende Signal der Steuerschaltung (210) zugeführt wird;
wobei die Erfassungsmittel (205) einen Stromwandler (206), der dazu eingerichtet ist, das den Differenzstrom repräsentierende Signal zu erfassen, und eine erste Gleichrichterstufe (207) umfassen, die dazu eingerichtet ist, das den Differenzstrom repräsentierende Signal gleichzurichten;
wobei der Stromwandler (206) eine erste primärseitige Wicklung (L1), die in Reihe mit der sekundärseitigen Wicklung (Ls) des Transformators (204) geschaltet ist, eine zweite primärseitige Wicklung (L2), die in Reihe mit dem Resonanzkondensator (Cp) angeordnet ist, und eine sekundärseitige Wicklung (L3) umfasst, wobei die sekundärseitige Wicklung (L3) mit der ersten primärseitigen Wicklung (L1) und mit der zweiten primärseitigen Wicklung (L2) desselben Transformators (206) gekoppelt ist;
wobei die sekundärseitige Wicklung (L3) desselben Transformators (206) dazu eingerichtet ist, das den Differenzstrom repräsentierende Signal auf Grundlage einer Differenz zwischen einem Strom, der durch die erste primärseitige Wicklung (L1) fließt, und einem Strom, der durch die zweite primärseitige Wicklung (L2) fließt, zu erfassen.

2. Isolierter getakteter Resonanzwandler (200) nach Anspruch 1, wobei die erste primärseitige Wicklung (L1) eine erste bifilare Wicklung umfasst und die zweite primärseitige Wicklung (L2) eine zweite bifilare Wicklung umfasst.

3. Isolierter getakteter Resonanzwandler (200) nach einem der vorhergehenden Ansprüche, wobei das den Differenzstrom repräsentierende Signal mittels eines Shunt-Widerstands (Rshunt) erfasst wird.

4. Isolierter getakteter Resonanzwandler (200) nach einem der vorhergehenden Ansprüche, wobei die Schaltstufe (201) eine Halbbrückenschaltung, HB-Schaltung, umfasst, wobei die HB-Schaltung zwei in Reihe geschaltete Schalter umfasst.

5. Isolierter getakteter Resonanzwandler (200) nach Anspruch 4, wobei ein Ausgangssignal des Stromwandlers (206) der Steuerschaltung (210) zugeführt wird; wobei die Steuerschaltung (210) dazu eingerichtet ist, ein Signal zum Einstellen eines Betriebsparameters mindestens eines Schalters der HB-Schaltung zu erzeugen.

6. Isolierter getakteter Resonanzwandler (200) nach einem der vorhergehenden Ansprüche, wobei der Wandler (200) eine zweite Gleichrichterstufe (208) umfasst, die dazu eingerichtet ist, einen Strom gleichzurichten, der den Ausgangsanschlüssen (202a, 202b) des Wandlers (200) zur Versorgung der LED-Last (202) zugeführt wird.

7. Isolierter getakteter Resonanzwandler (200) nach einem der vorhergehenden Ansprüche, wobei der Wandler (200) einen Ausgangskondensator (Cout) umfasst, wobei der Ausgangskondensator (Cout) dazu eingerichtet ist, einen Strom zu glätten, der den Ausgangsanschlüssen (202a, 202b) des Wandlers (200) zur Versorgung der LED-Last (202) zugeführt wird.

8. Isolierter getakteter Resonanzwandler (200) nach einem der vorhergehenden Ansprüche, wobei der Wandler (200) ein LLC-Wandler oder ein LCC-Wandler ist.

9. LED-Beleuchtungsvorrichtung (209), umfassend einen isolierten getakteten Resonanzwandler (200) nach einem der Ansprüche 1 bis 8 sowie mindestens ein LED-Modul (202), das mit Ausgangsanschlüssen (202a, 202b) des Wandlers (200) verbunden ist.

10. Verfahren (600) zum Erfassen eines sekundärseitigen Stroms eines isolierten getakteten Resonanzwandlers (200), wie z. B. eines LCC-Wandlers, wobei der Wandler (200) eine Schaltstufe (201) mit mindestens einem Schalter, der durch eine Steuerschaltung (210) des Wandlers (200) angesteuert wird, einen Resonanzkreis (203), der durch die Schaltstufe (201) versorgt wird, einen Transformator (204) als Isolationsstufe, wobei ein Resonanzkondensator (Cp) parallel zu einer sekundärseitigen Wicklung (Ls) des Transformators (204) geschaltet ist, und einen Stromwandler (206) umfasst, der eine erste primärseitige Wicklung (L1), die in Reihe mit der sekundärseitigen Wicklung (Ls) des Transformators (204) geschaltet ist, eine zweite primärseitige Wicklung (L2), die in Reihe mit dem Resonanzkondensator (Cp) angeordnet ist, und eine sekundärseitige Wicklung (L3) umfasst, wobei die sekundärseitige Wicklung (L3) mit der ersten primärseitigen Wicklung (L1) und mit der zweiten primärseitigen Wicklung (L2) desselben Transformators (206) gekoppelt ist, wobei das Verfahren (600) die Schritte umfasst:
- Versorgen (601) von Ausgangsanschlüssen (202a, 202b) des Wandlers (200) durch die sekundärseitige Wicklung (Ls) zur Versorgung einer LED-Last (202);
- Erfassen (602) eines einen Differenzstrom repräsentierenden Signals auf Grundlage einer Differenz zwischen einem ersten Strom, der durch die sekundärseitige Wicklung (Ls) fließt, und einem zweiten Strom, der durch den Kondensator (Cp) fließt, und
- Zuführen (603) des den Differenzstrom repräsentierenden Signals zu der Steuerschaltung (210),
wobei der Wandler (200) ferner eine erste Gleichrichterstufe (207) umfasst, die dazu eingerichtet ist, das den Differenzstrom repräsentierende Signal gleichzurichten, und wobei das Erfassen (602) eines einen Differenzstrom repräsentierenden Signals umfasst:
Erfassen des den Differenzstrom repräsentierenden Signals auf Grundlage einer Differenz zwischen einem Strom, der durch die erste primärseitige Wicklung (L1) fließt, und einem Strom, der durch die zweite primärseitige Wicklung (L2) fließt.

## Revendications

1. Convertisseur résonant commuté isolé (200), tel que par exemple un convertisseur LCC, pour alimenter une charge de LED (202), comprenant :
- un étage de commutation (201) ayant au moins un interrupteur commandé par un circuit de commande (210) du convertisseur (200),
- un circuit résonant (203) alimenté par l'étage de commutation (201),
- un transformateur (204) en tant qu'étage d'isolation,
- un condensateur de résonance (Cp), dans lequel le condensateur de résonance (Cp) est agencé en parallèle avec un enroulement côté secondaire (Ls) du transformateur (204), dans lequel l'enroulement côté secondaire (Ls) est agencé pour alimenter des bornes de sortie (202a, 202b) du convertisseur (200) alimentant la charge de LED (202),
- des moyens de détection (205) configurés pour détecter un signal représentant un courant différentiel sur la base d'une différence entre un premier courant circulant à travers l'enroulement côté secondaire (Ls) et un deuxième courant circulant à travers le condensateur (Cp), le signal représentant le courant différentiel étant fourni au circuit de commande (210) ;
dans lequel les moyens de détection (205) comprennent un transformateur de courant (206) configuré pour détecter le signal représentant le courant différentiel et un premier étage de redressement (207) configuré pour redresser le signal représentant le courant différentiel ;
dans lequel le transformateur de courant (206) comprend un premier enroulement côté primaire (L1) qui est connecté en série avec l'enroulement côté secondaire (Ls) du transformateur (204), un second enroulement côté primaire (L2) agencé en série avec le condensateur de résonance (Cp), et un enroulement côté secondaire (L3), dans lequel l'enroulement côté secondaire (L3) est couplé au premier enroulement côté primaire (L1) et au second enroulement côté primaire (L2) du même transformateur (206) ;
dans lequel l'enroulement côté secondaire (L3) du même transformateur (206) est configuré pour détecter le signal représentant le courant différentiel sur la base d'une différence entre un courant circulant à travers le premier enroulement côté primaire (L1) et un courant circulant à travers le second enroulement côté primaire (L2).

2. Convertisseur résonant commuté isolé (200) selon la revendication 1, dans lequel le premier enroulement côté primaire (L1) comprend un premier enroulement bifilaire et le second enroulement côté primaire (L2) comprend un second enroulement bifilaire.

3. Convertisseur résonant commuté isolé (200) selon l'une quelconque des revendications précédentes, dans lequel le signal représentant le courant différentiel est détecté au moyen d'une résistance shunt (Rshunt).

4. Convertisseur résonant commuté isolé (200) selon l'une quelconque des revendications précédentes, dans lequel l'étage de commutation (201) comprend une circuiterie de demi-pont, HB, dans lequel la circuiterie HB comprend deux interrupteurs en série.

5. Convertisseur résonant commuté isolé (200) selon la revendication 4, dans lequel un signal de sortie du transformateur de courant (206) est fourni au circuit de commande (210) ; dans lequel le circuit de commande (210) est configuré pour générer un signal destiné à régler un paramètre de fonctionnement d'au moins un interrupteur de la circuiterie HB.

6. Convertisseur résonant commuté isolé (200) selon l'une quelconque des revendications précédentes, dans lequel le convertisseur (200) comprend un second étage de redressement (208) configuré pour redresser un courant fourni aux bornes de sortie (202a, 202b) du convertisseur (200) pour alimenter la charge de LED (202).

7. Convertisseur résonant commuté isolé (200) selon l'une quelconque des revendications précédentes, dans lequel le convertisseur (200) comprend un condensateur de sortie (Cout), dans lequel le condensateur de sortie (Cout) est configuré pour lisser un courant fourni aux bornes de sortie (202a, 202b) du convertisseur (200) pour alimenter la charge de LED (202).

8. Convertisseur résonant commuté isolé (200) selon l'une quelconque des revendications précédentes, dans lequel le convertisseur (200) est un convertisseur LLC ou un convertisseur LCC.

9. Dispositif d'éclairage à LED (209) comprenant un convertisseur résonant commuté isolé (200) selon l'une quelconque des revendications 1 à 8 ainsi qu'au moins un module LED (202) connecté aux bornes de sortie (202a, 202b) du convertisseur (200).

10. Procédé (600) de détection d'un courant côté secondaire d'un convertisseur résonant commuté isolé (200), tel que par exemple un convertisseur LCC, dans lequel le convertisseur (200) comprend un étage de commutation (201) ayant au moins un interrupteur commandé par un circuit de commande (210) du convertisseur (200), un circuit résonant (203) alimenté par l'étage de commutation (201), un transformateur (204) en tant qu'étage d'isolation, dans lequel un condensateur de résonance (Cp) est connecté en parallèle avec un enroulement côté secondaire (Ls) du transformateur (204), et un transformateur de courant (206) comprenant un premier enroulement côté primaire (L1) qui est connecté en série avec l'enroulement côté secondaire (Ls) du transformateur (204), un second enroulement côté primaire (L2) agencé en série avec le condensateur de résonance (Cp), et un enroulement côté secondaire (L3), dans lequel l'enroulement côté secondaire (L3) est couplé au premier enroulement côté primaire (L1) et au second enroulement côté primaire (L2) du même transformateur (206), le procédé (600) comprenant les étapes consistant à :
- alimenter (601) des bornes de sortie (202a, 202b) du convertisseur (200) par l'enroulement côté secondaire (Ls) pour alimenter une charge de LED (202) ;
- détecter (602) un signal représentant un courant différentiel sur la base d'une différence entre un premier courant circulant à travers l'enroulement côté secondaire (Ls) et un second courant circulant à travers le condensateur (Cp), et
- fournir (603) le signal représentant le courant différentiel au circuit de commande (210),
dans lequel le convertisseur (200) comprend en outre un premier étage de redressement (207) configuré pour redresser le signal représentant le courant différentiel, et
dans lequel la détection (602) d'un signal représentant un courant différentiel comprend :
la détection du signal représentant le courant différentiel sur la base d'une différence entre un courant circulant à travers le premier enroulement côté primaire (L1) et un courant circulant à travers le second enroulement côté primaire (L2).
